(19) Europäisches Patentamt / European Patent Office / Office européen des brevets

(11) EP 3 471 157 A1

(12) EUROPEAN PATENT APPLICATION

(43) Date of publication:
17.04.2019 Bulletin 2019/16

(51) Int Cl.:
*H01L 41/09* (2006.01)     *H01L 31/055* (2014.01)

(21) Application number: 17196297.0

(22) Date of filing: 13.10.2017

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(71) Applicant: Vestel Elektronik Sanayi ve Ticaret A.S.
45030 Manisa (TR)

(72) Inventors:
• ULUAG, Onur
  45030 Manisa (TR)
• BAKANOGLU, Kagan
  45030 Manisa (TR)

(74) Representative: Ascherl, Andreas et al
KEHL, ASCHERL, LIEBHOFF & ETTMAYR
Patentanwälte - Partnerschaft
Emil-Riedel-Strasse 18
80538 München (DE)

(54) **DEVICE AND METHOD FOR TRANSFORMING LIGHT INTO ELECTRIC ENERGY BY MODIFYING THE VIBRATIONS OF AT LEAST ONE ACTIVE LAYER**

(57) The present invention refers to a device (1) for transforming light into electric energy. The device (1) according to the present invention comprises at least a wave length modifying and transforming layer (2), an actuator for actuating the wave length modifying and transforming layer (2), wherein the actuator causes the wave length modifying and transforming layer (2) to vibrate with a predefined frequency to modify at least light of one wave length, in particularly incident and/or reflected light, by means of doppler redshift, wherein the wave length modifying and transforming layer (2) transforms the modified light into electric energy.

Fig. 1

## Description

The present invention refers according to claim 1 to a device for transforming light into electric energy and according to claim 12 to a method for transforming light into electric energy.

## Background of the invention

Document US 8,901,802 B1 discloses an energy harvesting device which uses carbon nanotubes to absorb the sunlight and generate energy from that. Also, it contains piezoelectric cantilevers which get deformed due to energy produced by carbon nanotubes and thus, the piezoelectric effect creates electrical energy.

Document US 2013/0276869 A1 discloses a flag shaped harvesting device with a nano-generator structure harvesting energy from vibration of nano-wires. This harvesting device works with sunlight and with wind.

Document US 2015/0256118 A1 discloses a piezo voltaic energy harvester containing a photovoltaic layer and a dielectric laminar to harvest energy from sunlight as well as other environmental sources which may cause vibration in the dielectric laminar.

All three referenced documents use vibrations to harvest energy. The frequency spectrum of light which is used to harvest light is the same as active layers of regular photovoltaic cells use.

The frequency spectrum of an active layer can be adjusted by doping specific amount of substances. But tuning a layer to infrared spectrum does not work because band gap of material becomes too much for infrared light energy to free (release) electrons which results electricity.

## Object of the present invention

It is the object of the present invention to provide a device and a method which is more efficient compared to state of the art photovoltaic cells.

## Description of the invention

The before mentioned object is solved by a device, in particularly a photovoltaic cell, according to claim 1 for transforming light into electric energy. The device according to the present invention preferably comprises at least a wave length modifying and transforming layer, an actuator for actuating the wave length modifying and transforming layer, wherein the actuator causes the wave length modifying and transforming layer to vibrate with a predefined frequency to modify at least light of one wave length, in particularly incident and/or reflected light, by means of doppler shift, in particularly doppler redshift, wherein the wave length modifying and transforming layer transforms the modified light into electric energy.

This solution is beneficial since vibrations are created (or amplified) on purpose by applying electric energy to at least one layer. The vibrations on that layer cause Doppler Effect and thus changing the frequency of received light. By varying amplitude and frequency of the electrical energy applied to the vibrating layer, the speed of the layer changes and thus the Doppler Shift. This enables that layer to absorb other frequencies which are not (or cannot) tuned by the layer. Therefore, vibrations are created on purpose in order to harvest more electromagnetic energy by absorbing the energy from yet unabsorbable frequency spectrums such as infrared waves.

Thus, present invention relates to devices respectively photovoltaic cells, and more particularly, a layer which is vibrated intentionaly by electrical energy in order to change the absorbed spectrum range and benefit from unabsorbed infrared spectrum and/or another spectrum.

Further preferred embodiments are subject matter of the dependent claims and/or of the following specification passages.

According to a preferred embodiment of the present invention the wave length modifying and transforming layer is covered by at least one piezo electric material or comprises at least one piezo electric material, in particularly the wave length modifying and transforming layer is preferably doped with a piezo electric material, wherein the actuator provides electric energy for stimulating the piezo electric material. This embodiment is beneficial since the overall thickness of the wave length modifying and transforming layer does not increase significantly. Alternatively, the actuator generates vibrations, wherein the vibrations generated by the actuator are transferred to the wave length modifying and transforming layer, in particular by means of a contact between the wave length modifying and transforming layer and the actuator.

The wave length modifying and transforming layer comprises according to a further preferred embodiment of the present invention a semiconductor material. Thus, the wave length modifying and transforming layer comprises at least one semiconductor material of a first group of materials, wherein the first group of materials comprises at least Silicon, Germanium, Boron, Phosphorus, Gallium, Arsenic, Aluminum, Indium, Antimony, Lithium. The wave length modifying and transforming layer/s preferably comprise at least one material of a second group of materials and/or of a third group of materials, wherein the second group comprises piezo electric material in particularly at least Barium Titanate, Gallium Phosphate, Sodium Bismuth Titanate, wherein the third group comprises ferro magnetic material in particularly at least Cobalt, Iron, Nickel. This embodiment is beneficial since the first group of materials enables transforming light waves into electric energy. The second group of materials enables electric actuation, in particular excitation respectively vibration, of the wave length modifying and transforming layer. The third group of materials enables electromagnetic actuation, in particular excitation respectively vibration, of the wave length modifying and transforming layer.

At least one further wave length modifying and transforming layer is arranged according to a further preferred embodiment of the present invention above the wave length modifying and transforming layer. The further wave length modifying and transforming layer has preferably the same or different properties compared to the wave length modifying and transforming layer (respectively first wave length modifying and transforming layer). This embodiment is beneficial since light passing the first wave length modifying and transforming layer can be modified and/or transformed into electric energy by the further wave length modifying and transforming layer.

The further wave length modifying and transforming layer and the wave length modifying and transforming layer are according to a further preferred embodiment of the present invention arranged in a stacked manner respectively in a stacked like manner respectively in parallel to each other respectively facing each other. The wave length modifying and transforming layer are preferably fixed to a frame, in particularly a common frame, on one or more sides (preferably at least or exactly 2 sides or 4 sides). They can also be fixed a flexible grid frame which is also fixed to a frame. The further wave length modifying and transforming layer and the wave length modifying and transforming layer are preferably arranged in a predefined distance to each other, wherein the predefined distance corresponds to the sum of the amplitudes of the further wave length modifying and transforming layer and the wave length modifying and transforming layer or wherein the predefined distance is smaller as the sum of the amplitudes of the further wave length modifying and transforming layer and the wave length modifying and transforming layer or wherein the predefined distance is bigger as the sum of the amplitudes of the further wave length modifying and transforming layer and the wave length modifying and transforming layer. This embodiment is beneficial since the height of the stack can be designed with respect to conditions respectively amplitudes generated during operation. Doppler Equation

$$f' = f\left(\frac{v + v_o}{v - v_s}\right)$$

is preferably used to determine the frequency shift. f' is the shifted frequency; f is the frequency of light wave; v is the velocity of light; v0 is the velocity of vibrating layer; vs is the velocity of sun which is negligible, taken 0. If the appeared frequency is needed, formula can be manipulated as changing v0 with vs. Velocity of vibrating layer is preferably v0(t)= d[A.sin(wt)] / dt. The amplitude preferably defines the separation distance between layers. Manufacturers can decide the limits of amplitude and frequency of oscillation and the wanted frequency shift of light.

A stack of transforming layers respective active layers is arranged according to a further preferred embodiment of the present invention above or below the wave length modifying and transforming layer or above or below the wave length modifying and transforming layer and the further wave length modifying and transforming layer. This embodiment is beneficial since the transforming layers respective active layers already transform light waves into electric energy. Thus, the overall efficiency is further increased in case such active layers are combined with wave length modifying and transforming layer/s, since a broader overall spectrum of light can be used.

A reflection means for reflecting light that irradiates through the wave length modifying and transforming layer, in particularly through the stack of transforming layers and the wave length modifying and transforming layer and the further wave length modifying and transforming layer, is provided according to a further preferred embodiment of the present invention. Due to back reflector respectively reflection means, non-absorbed light is reflected and this changes the direction of light and logical source according to observer. In this way, when vibrating layer moves away from the actual light source, it actually moves towards to reflected light. This enables both away and toward motion can be affected by doppler red shift which increases observed frequency. Adding second layer with phase shift also enables absorbing target frequency light when another layer slows down. When a layer slows down, it also absorbs non-absorbed reflected light without doppler shift. This system is advantageous as long as energy consumed to vibrate the layers is less than the energy converted by the vibrating layers.

At least a third wave length modifying and transforming layer is arranged according to a further preferred embodiment together with the wave length modifying and transforming layer and the further wave length modifying and transforming layer in stacked manner, wherein the stack of wave length modifying and transforming layers comprises at least three layers for transforming light of different wave length into electric energy and wherein the stack of transforming layers comprises at least three layers for transforming light of different wave length into electric energy. Preferably is at least one wave length modifying and transforming layer and/or one transforming layer configured as blue cell and/or preferably at least one wave length modifying and transforming layer and/or one transforming layer is configured as green cell and/or preferably at least one wave length modifying and transforming layer and/or one transforming layer is configured as red cell. This embodiment is beneficial since the overall efficiency increases due to differently configured layers.

The actuator actuates the wave length modifying and transforming layer according to a further preferred embodiment to modify light of the infrared spectrum, in particularly wave length between 800nm and 1 mm, in particularly 800nm to 10000nm or 800nm to 2000nm or 800nm to 1500nm or 800nm to 1200nm or 800nm to 1000nm. This embodiment is beneficial since the infrared spectrum transmits significant energy, wherein at least a fraction of said energy can be transformed into electric energy.

According to a further preferred embodiment of the present invention a light sensor is provided, wherein the light sensor senses the amount of light of the infrared spectrum, wherein the actuator means causes the wave length modifying and transforming layer to vibrate in case the amount of light, in particularly of light of the infrared spectrum, is above a predefined threshold. The predefined threshold preferably defines an amount of light which enables an output of electric energy which is higher than the electric energy required by the actuator for vibrating the wave length modifying and transforming layer/s. This embodiment is beneficial since the actuator is preferably operated in case the wave length modifying and transforming layer outputs less electric energy based on wave modification compared to the electric energy required for operating the actuator.

The above-mentioned object is also solved according to claim 12 by a method for transforming light into electric energy. The method according to the invention preferably comprises at least the steps:

Providing a device for transforming light into electric energy, wherein the device comprises a wave length modifying and transforming layer and an actuator for vibrating the wave length modifying and transforming layer; Vibrating the wave length modifying and transforming layer with a predefined frequency by means of the actuator, wherein the vibrating wave length modifying and transforming layer causes a modification of light of at least one wave length, wherein the light is modified by means of a doppler redshift, wherein the wave length modifying and transforming layer or another transforming layer transforms the modified light into electric energy.

The device comprises according to a further preferred embodiment of the present invention at least one further wave length modifying and transforming layer, wherein the wave length modifying and transforming layers are vibrated by one or multiple actuators. The vibrations of the individual wave length modifying and transforming layers is preferably caused in such a manner that the vibrations of the individual wave length modifying and transforming layers are out of phase, the resulting phase shift corresponds to the equitation: 2*π/(Number of wave length modifying and transforming layers).

Thus, the preferred oscillation is out of phase. For example, if there are 2 vibrating layers, the preferred phase shift is 180 degrees, and if there are 3 vibrating layers then it is preferably 120 degrees.

The device further preferably comprises at least one transforming layer, wherein the transforming layer vibrates less compared to the wave length modifying and transforming layers in case the wave length modifying and transforming layers are vibrated by the actuator/s, the electric power provided by at least one transforming layer is measured, wherein the actuator is operated to vibrate the wave length modifying and transforming layer in case the measured electric power is above a predefined threshold.

Throughout the present description and claims, the term "source" is used to indicate light source and the term "observer" is used to indicate light receiver.

Further benefits, goals and features of the present invention will be described by the following specification of the attached figures, in which exemplarily components of the invention are illustrated. Components of the devices, units and methods according to the invention, which match at least essentially with respect to their function can be marked with the same reference sign, wherein such components do not have to be marked or described multiple times with respect to said figures. In the following the invention is just exemplarily described with respect to the attached figures.

## Brief description of the drawings

Fig. 1     shows schematically a device according to the present invention, wherein the device comprises multiple layers forming a stack;

Fig. 2a     shows schematically a chart of vibration motion of an actuated layer; and

Fig. 2b     shows schematically a chart, wherein the observer layer is tuned to a specific frequency spectrum.

**Detailed description of the drawings**

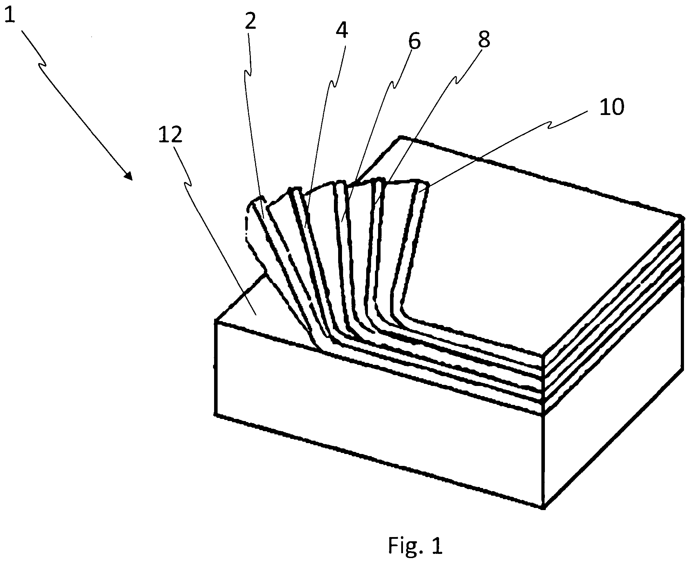

Fig. 1 shows an example of a device 1 according to the present invention. Device 1 preferably comprises at least one wave length modifying and transforming layer 2. Additionally, the device can comprise one or multiple further wave length modifying and transforming layers. However, the device preferably comprises a transforming layer, in particularly multiple transforming layers, wherein one or exactly one or at least one transforming layer represents a red cell 4 or one or exactly one or at least one transforming layer represents a green cell 6 or one or exactly one or at least one transforming layer represents a blue cell 8. The transforming layer or layers is/are preferably arranged above the wave length modifying and transforming layer/s 2. Thus, light, in particularly sun light, preferably passes through the transforming layer/s before arriving at the wave length modifying and transforming layer/s 2.

Silicon based photovoltaic cells have several active and passive layers 4, 6, 8. Thus, fig. 1 shows an example of a multi-layer structure of a photovoltaic cell.

Layer count may differ from implementation to implementation but generic structure of layers is preferably similar in all embodiments according to the present invention.

1 st layer 10 from top to bottom is a passive layer that is transparent, and has low refractive index material that allows light to pass through. This layer 10 preferably comprises or consists of a transparent conductive oxide film and thus forms a cover layer.

Inner layers 2, 4, 6, 8 are active photovoltaic layers each has a different tuning frequency spectrum. Inner layer count may differ from implementation to implementation. Infrared light passes through the inner layers 2, 4, 6, 8.

The last layer is a reflective surface 12 that is called back reflector in the domain. It reflects non-absorbed light back to the active layers 2, 4, 6, 8. The reflective surface 12 is preferably part of a substrate, wherein the active layers 2, 4, 6, 8 are arranged on said substrate.

The frequency spectrum of an active layer 4, 6, 8 can be adjusted by doping specific amount of substances. But tuning a layer 4, 6, 8 to infrared spectrum does not work because band gap of material becomes too much for infrared light energy to free (release) electrons which results electricity.

The proposed system, overcomes this problem, in particularly by adding one or several active layers 2 to a substrate, in particularly a state of the art structure. New layer/s 2 are vibrated by energy, in particularly by means of electric energy that is gathered from other active layers or which is supplied externally.

Amorphous silicon photovoltaic cells are perfect candidate for doping a layer with piezoelectric materials that enables layers to vibrate. But crystalline or other state of the art nano-structures can also be used. Vibrating layers with external vibration source is also an option instead of doping with piezoelectric material.

This vibration creates doppler shift and change the observed frequency of received electromagnetic wave.

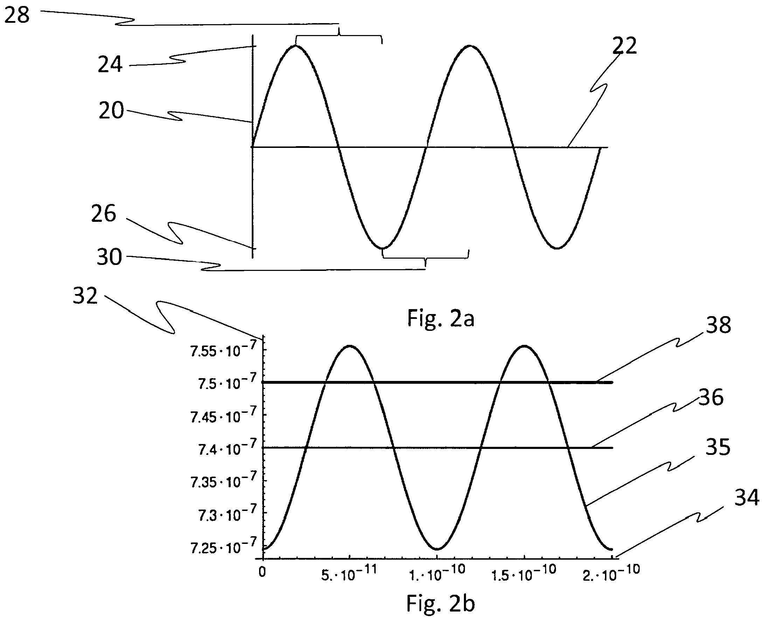

An example vibration motion respectively displacement 20 of a layer is shown in Figure 2a. As an example, X $\mu$m, in particular 100$\mu$m, displacement for each end (24, 26) is given but amplitude and frequency of motion can be changed according to requirements and limitations. In Figure 2a, center of layer is moving between reference numbers 24, 26, in particularly between 100$\mu$m to -100$\mu$m. Plot shows time 22 after system sits to steady state. The velocity plot of vibrating layer is just the derivative of Figure 2a.

Figure 2a shows that a period of oscillation is T. From T/4 to 3T/4 (reference number 28), motion is away from source (sun), and from 3T/4 to 5T/4 (reference number 30), motion is towards to source (sun).

In Figure 2b, observer layer is tuned to specific frequency spectrum and line 36 shows center frequency. Curve 35 shows actual wavelength of light that is observed as tuned frequency by observer. Line 38 is the start of Infrared spectrum which is selected as target frequency for this example. Changing the tuned frequency of layer 2 or amplitude or frequency of oscillation changes minima and maxima of curve 35. The numbers are given as an example.

Thus, the present invention refers to a device 1 for transforming light into electric energy. The device 1 according to the present invention comprises at least a wave length modifying and transforming layer 2, an actuator for actuating the wave length modifying and transforming layer 2, wherein the actuator causes the wave length modifying and transforming layer 2 to vibrate with a predefined frequency to modify at least light of one wave length, in particularly incident and/or reflected light, by means of doppler redshift, wherein the wave length modifying and transforming layer 2 transforms the modified light into electric energy.

<div align="center">List of reference numbers</div>

| 1 | Device | 22 | time |
|---|---|---|---|
| 2 | wave length modifying and transforming layer | 24 | max displacement in first direction |
| 4 | red cell / first transforming layer | 26 | max displacement in second direction |

(continued)

| 6 | green cell /second transforming layer | 28 | 2/4-3/4T |
| | | 30 | 3/4-5/4T |
| 8 | blue cell / third transforming layer | 32 | wavelength |
| 10 | transparent conductive oxide film / cover layer | 34 | time |
| 12 | reflection means | 35 | curve |
| 14 | carrying substrate | 36 | center frequency |
| 20 | displacement | 38 | start of infrared spectrum |

**Claims**

1.  Device (1) for transforming light into electric energy,
    at least comprising
    a wave length modifying and transforming layer (2),
    an actuator for actuating the wave length modifying and transforming layer (2),
    wherein the actuator causes the wave length modifying and transforming layer (2) to vibrate with a predefined frequency to modify at least light of one wave length, in particular incident and/or reflected light, by means of doppler shift, in particular doppler redshift,
    wherein the wave length modifying and transforming layer (2) transforms the modified light into electric energy.

2.  Device according to claim 1,
    **characterized in that**
    the wave length modifying and transforming layer (2) comprises a piezo electric material, in particular the wave length modifying and transforming layer (2) is doped with a piezo electric material, wherein the actuator provides electric energy for stimulating the piezo electric material
    or
    the actuator generates vibrations, wherein the vibrations generated by the actuator are transferred to the wave length modifying and transforming layer.

3.  Device according to claim 1 or 2,
    **characterized in that**
    the wave length modifying and transforming layer (2) comprises a semiconductor material.

4.  Device according to claim 3,
    **characterized in that**
    the wave length modifying and transforming layer comprises (2) at least one material of a first group of materials,
    wherein the first group comprises at least Silicon, Germanium, Boron, Phosphorus, Gallium, Arsenic, Aluminum, Indium, Antimony, Lithium
    and
    at least one material of a second group of materials or of a third group of materials,
    wherein the second group comprises piezo electric material in particularly at least Barium Titanate, Gallium Phosphate, Sodium Bismuth Titanate,
    wherein the third group comprises ferro magnetic material in particularly at least Cobalt, Iron, Nickel.

5.  Device according to any of the preceding claims,
    **characterized in that**
    at least one further wave length modifying and transforming layer is arranged above the wave length modifying and transforming layer.

6.  Device according to any of the preceding claims,
    **characterized in that**
    the further wave length modifying and transforming layer and the wave length modifying and transforming layer (2) are arranged in stacked manner,
    wherein the further wave length modifying and transforming layer and the wave length modifying and transforming layer (2) are arranged in a predefined distance,

wherein the predefined distance corresponds to the sum of the amplitudes of the further wave length modifying and transforming layer and the wave length modifying and transforming layer (2)

or

wherein the predefined distance is smaller as the sum of the amplitudes of the further wave length modifying and transforming layer and the wave length modifying and transforming layer (2)

or

wherein the predefined distance is bigger as the sum of the amplitudes of the further wave length modifying and transforming layer and the wave length modifying and transforming layer (2).

7. Device according to any of the preceding claims,
**characterized in that**
a stack of transforming layers (4, 6, 8) is arranged above or below the wave length modifying and transforming layer (2) or above or below the wave length modifying and transforming layer (2) and the further wave length modifying and transforming layer.

8. Device according to any of the preceding claims,
**characterized in that**
a reflection means (12) for reflecting light that irradiates through the wave length modifying and transforming layer (2), in particular through the stack of transforming layers (4, 6, 8) and the wave length modifying and transforming layer (2) and the further wave length modifying and transforming layer, is provided.

9. Device according to any of the preceding claims,
**characterized in that**
at least a third wave length modifying and transforming layer is arranged together with the wave length modifying and transforming layer (2) and the further wave length modifying and transforming layer in stacked manner, wherein the stack of wave length modifying and transforming layers comprises at least three layers for transforming light (4, 6, 8) of different wave length into electric energy

and

wherein the stack of transforming layers (4, 6, 8) comprises at least three layers for transforming light of different wave length into electric energy.

10. Device according to any of the preceding claims,
**characterized in that**
the actuator actuates the wave length modifying and transforming layer (2) to modify light of the infrared spectrum.

11. Device according to any of the preceding claims,
**characterized in that**
a light sensor is provided, wherein the light sensor senses the amount of light of the infrared spectrum,
wherein the actuator means causes the wave length modifying and transforming layer to vibrate in case the amount of light, in particular of light of the infrared spectrum, is above a predefined threshold.

12. Method for transforming light into electric energy,
at least comprising the steps
providing a device (1) for transforming light into electric energy,
wherein the device (1) comprises a wave length modifying and transforming layer (2) and an actuator for vibrating the wave length modifying and transforming layer,
vibrating the wave length modifying and transforming layer (2) with a predefined frequency by means of the actuator,
wherein the vibrating wave length modifying and transforming layer (2) causes a modification of light of at least one wave length,
wherein the light is modified by means of a doppler redshift,
wherein the wave length modifying and transforming layer (2) or another transforming layer transforms the modified light into electric energy.

13. Method according to claim 12,
**characterized in that**
the device (1) comprises at least one further wave length modifying and transforming layer, wherein the wave length modifying and transforming layers are vibrated by one or multiple actuators.

**14.** Method according to claim 13,
**characterized in that**
the vibrations of the individual wave length modifying and transforming layers is caused in such a manner that the vibrations of the individual wave length modifying and transforming layers are out of phase, the resulting phase shift corresponds to the equitation: $2*\pi/$(Number of wave length modifying and transforming layers).

**15.** Method according to any of the preceding claims,
**characterized in that**
the device (1) further comprises at least one transforming layer (4, 6, 8), wherein the transforming layer (4, 6, 8) vibrates less compared to the wave length modifying and transforming layers in case the wave length modifying and transforming layers are vibrated by the actuator/s,
the electric power provided by at least one transforming layer is measured,
wherein the actuator is operated to vibrate the wave length modifying and transforming layer/s in case the measured electric power is above a predefined threshold.

Fig. 1

28

24

20

22

26

30

**Fig. 2a**

32

38

36

35

34

$7.55 \cdot 10^{-7}$
$7.5 \cdot 10^{-7}$
$7.45 \cdot 10^{-7}$
$7.4 \cdot 10^{-7}$
$7.35 \cdot 10^{-7}$
$7.3 \cdot 10^{-7}$
$7.25 \cdot 10^{-7}$

0      $5 \cdot 10^{-11}$      $1 \cdot 10^{-10}$      $1.5 \cdot 10^{-10}$      $2 \cdot 10^{-10}$

**Fig. 2b**

Europäisches
Patentamt

European
Patent Office

Office européen
des brevets

## EUROPEAN SEARCH REPORT

Application Number

EP 17 19 6297

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 585 416 A (MELLEN HOWARD G) 15 June 1971 (1971-06-15) * column 2, lines 8-66; figure 1 * ----- | 1 | INV. H01L41/09 H01L31/055 |
| X | WO 2012/042259 A2 (UNIV BOLTON [GB]; HADIMANI MAGUNDAPPA L RAVI [IN]; SIORES ELIAS [GB]) 5 April 2012 (2012-04-05) * page 12, lines 1-8; figure 1 * ----- | 1 | |
| A | US 2011/075961 A1 (HERRMANN JR RICHARD J [US]) 31 March 2011 (2011-03-31) * paragraphs [0023] - [0062]; figures 1-11 * ----- | 1-15 | |
| A | WO 2009/024509 A2 (BASF SE [DE]; RENNIG ALFRED [DE]; HAMMERMANN MARKUS [DE]; EICKEMEYER F) 26 February 2009 (2009-02-26) * page 3, line 29 - page 8, line 22; figures 1,2 * ----- | 1,12 | |
| X | US 8 981 213 B1 (MICALLEF JOSEPH A [US]) 17 March 2015 (2015-03-17) * column 2, line 15 - column 6, line 25; figures 1,2 * ----- | 1 | TECHNICAL FIELDS SEARCHED (IPC) H01L |
| A | US 2003/056820 A1 (MACDONALD STUART G [US]) 27 March 2003 (2003-03-27) * paragraphs [0008] - [0040]; figures 1,2 * ----- | 1,12 | |

The present search report has been drawn up for all claims

| Place of search | Date of completion of the search | Examiner |
|---|---|---|
| Munich | 12 April 2018 | Steiner, Markus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

....................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 17 19 6297

This annex lists the patent family members relating to the patent documents cited in the above-mentioned European search report.
The members are as contained in the European Patent Office EDP file on
The European Patent Office is in no way liable for these particulars which are merely given for the purpose of information.

12-04-2018

| Patent document cited in search report | | Publication date | Patent family member(s) | | Publication date |
|---|---|---|---|---|---|
| US 3585416 | A | 15-06-1971 | NONE | | |
| WO 2012042259 | A2 | 05-04-2012 | BR | 112013007019 A2 | 14-06-2016 |
| | | | CN | 103155177 A | 12-06-2013 |
| | | | EP | 2622647 A2 | 07-08-2013 |
| | | | EP | 2650929 A1 | 16-10-2013 |
| | | | ES | 2529252 T3 | 18-02-2015 |
| | | | JP | 5897579 B2 | 30-03-2016 |
| | | | JP | 2013545262 A | 19-12-2013 |
| | | | US | 2013257156 A1 | 03-10-2013 |
| | | | WO | 2012042259 A2 | 05-04-2012 |
| US 2011075961 | A1 | 31-03-2011 | US | 2011075961 A1 | 31-03-2011 |
| | | | US | 2012045164 A1 | 23-02-2012 |
| | | | WO | 2011038183 A1 | 31-03-2011 |
| WO 2009024509 | A2 | 26-02-2009 | AU | 2008290641 A1 | 26-02-2009 |
| | | | CN | 101828264 A | 08-09-2010 |
| | | | EP | 2191515 A2 | 02-06-2010 |
| | | | IL | 203819 A | 29-09-2016 |
| | | | JP | 5562238 B2 | 30-07-2014 |
| | | | JP | 2010537417 A | 02-12-2010 |
| | | | KR | 20100056531 A | 27-05-2010 |
| | | | US | 2011114174 A1 | 19-05-2011 |
| | | | US | 2015144192 A1 | 28-05-2015 |
| | | | WO | 2009024509 A2 | 26-02-2009 |
| | | | ZA | 201001812 B | 25-05-2011 |
| US 8981213 | B1 | 17-03-2015 | NONE | | |
| US 2003056820 | A1 | 27-03-2003 | US | 2003056820 A1 | 27-03-2003 |
| | | | WO | 03028115 A1 | 03-04-2003 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8901802 B1
- US 20130276869 A1

- US 20150256118 A1